# EUROPÄISCHE PATENTSCHRIFT

(11) **EP 2 132 602 B1**
(45) Veröffentlichungstag und Bekanntmachung des Hinweises auf die Patenterteilung: **24.06.2015**
(21) Anmeldenummer: 08735035.1
(22) Anmeldetag: 04.04.2008
(51) Int. Cl.: G03F 7/20

(54) **VERFAHREN UND VORRICHTUNG ZUM ABBILDEN EINER PROGRAMMIERBAREN MASKE AUF EINEM SUBSTRAT**
METHOD AND DEVICE FOR IMAGING A PROGRAMMABLE MASK ON A SUBSTRATE
PROCEDE ET DISPOSITIF PERMETTANT DE REPRESENTER UN MASQUE PROGRAMMABLE SUR UN SUBSTRAT

(30) Priorität: 05.04.2007 DE 102007016926
(43) Veröffentlichungstag der Anmeldung: 16.12.2009
(73) Patentinhaber: Heidelberg Instruments Mikrotechnik GmbH, 69126 Heidelberg (DE)
(72) Erfinder: MANGOLD, Alexander, 67071 Ludwigshafen (DE); BECKER, Udo, 69253 Heiligkreuzsteinach (DE); DIEZ, Steffen, 69120 Heidelberg (DE); KAPLAN, Roland, 69126 Heidelberg (DE)
(74) Vertreter: Schmitt, Meinrad
(86) Internationale Anmeldenummer: PCT/EP2008/002710
(87) Internationale Veröffentlichungsnummer: WO 2008/122419

(56) Entgegenhaltungen:
- DE-A1- 10 317 050
- CHOKSI N ET AL: "Maskless extreme ultraviolet lithography" JOURNAL OF VACUUM SCIENCE AND TECHNOLOGY: PART B, AVS / AIP, MELVILLE, NEW YORK, NY, US, Bd. 17, Nr. 6, 1. November 1999 (1999-11-01), Seiten 3047-3051, XP002183158 ISSN: 1071-1023

## Beschreibung

Die Erfindung bezieht sich auf ein Verfahren zum Abbilden einer programmierbaren Maske auf einem Substratgemäß den im Oberbegriff des Patentanspruchs 1 angegebenen Merkmalen. Ferner bezieht sich die Erfindung auf die Verwendung einer Vorrichtung zur Durchführung des Verfahrens.

Aus dem Dokument D1: CHOKSI N ET AL: "Maskless extreme ultraviolet lithography" JOURNAL OF VACUUM SCIENCEAND TECHNOLOGY: PART B, AVS/AIP, MELVILLE, NEW YORK, NY, US, Bd. 17, Nr. 6, 1. November 1999 (1999-11-01), Seiten 3047-3051, XP002183158 ISSN: 1071-1023" ist ein derartiges Verfahren zum Abbilden eines mittels einer programmierbaren Maske erzeugten Musters auf einem Substrat bekannt, welches eine fotoempfindliche Schicht aufweist. Mitteils einer Beleuchtungseinheit werden Beleuchtungsflecken in einem Belichtungsraster erzeugt und ferner werden über eine optische Einheit Einzelabbildungen auf dem Substrat ohne Veränderung der Größe erzeugt. Es erfolgt kein Versatz von Beleuchtungsflecken oder Belichtungspunkten mit zwei oder mehr Belichtungsvorgängen mit gegeneinander versetztem Belichtungsraster.

Die Standardverfahren der Photolithographie bilden ein auf einer Maske vorgefertigtes Vorlagemuster mittels photolithographischer Verfahren in festem Abbildungsverhältnis auf ein Substrat ab. Dazu wird die Maske hinterleuchtet, und das Bild wird über eine feste Optik auf ein Substrat aufgebracht, welches auf einem Trägermaterial eine photoempfindliche Schicht trägt. Diese Schicht wird durch die von der Maske gegebenen Abdeckungen der Beleuchtungsstrahlung selektiv belichtet, wodurch sich ein Abbild der Maske ergibt, wenn die photoempfindliche Schicht entwickelt wird. Je nach Anwendung kann das Abbild bereits das fertige Produkt sein, oder aber es kann genutzt werden, um darunterliegende Materialschichten entsprechend den erzeugten Öffnungen in der Schicht selektiv zu bearbeiten. Solche maskenabbildende photolithographische Verfahren werden zur Fertigung beispielsweise von Leiterplatten oder Flachbildschirmen verwendet. Die abzubildenden Masken enthalten kleine Strukturen, wie beispielsweise Leiterbahnen oder allgemein geometrische Strukturen, welche auf das Substrat abzubilden bzw. zu kopieren sind. Die typische Größe derartiger Strukturen hängt von der jeweiligen Anwendung ab und beträgt heute in der Leiterplattentechnologie beispielsweise 10 bis 50µm. Bei der Produktion von Flachbildschirmen ist mit Strukturgrößen bis hinab zu 1 bis 2µm zu rechnen. Die Masken liegen bei den derzeitigen Standardverfahren meist als komplette Vorlage des Gesamtmusters in Form von Filmen, Emulsionsmasken, Chrommasken oder dergleichen vor, welche 1:1 auf das Substrat übertragen wird. Der Nachteil dieser Verfahren ist, dass für jedes abzubildende Muster zunächst eine eigene Maske erstellt werden muss, und dass die Masken mit der Zeit durch das Be- und Entladen einer Abnutzung unterliegen.

Aus der US 6 291 110 B1 ist daher ein neueres Verfahren bekannt, bei welchem als Vorlage eine in das Abbildungssystem integrierte programmierbare Einheit oder Maske vorgesehen ist, in welche die abzubildenden Daten während des Kopiervorganges eingespeist und von jener dargestellt werden. Mittels einer zwischen der Maske und dem Substrat angeordneten Abbildungsoptik wird die durch die Maske hindurchtretende elektromagnetische Strahlung und somit die abzubildenden Strukturen verkleinert. Eine programmierbare Maske kann kleiner als das Substrat sein, und durch Aneinanderfügen von in die Maske programmierten Vorlagenausschnitten können dennoch große Substrate belichtet werden. Dadurch ist keine großflächige Maskenhalterung erforderlich. Auch die Beleuchtungseinheit und die Abbildungsoptik müssen nur für kleine Flächen ausgelegt sein. Als programmierbare Masken kommen unter anderem LCDs, Mikrospiegelanordnungen oder Phaseshift-Anordnungen in eindimensionalen oder zweidimensionalen Anordnungen zum Einsatz. Mittels innerhalb des Streifens oder der Fläche punktweise kontrollierter Absorption, Reflexion oder Diffraktion kann mit diesen Elementen die Intensität der zur Belichtung genutzten Strahlung kontrolliert werden, um belichtete oder unbelichtete Bereiche zu erzeugen. Die Beleuchtungsintensität kann dabei punktweise in Stufen oder kontinuierlich geregelt werden, wodurch auch Grauwerte erzeugt werden können.

Eine Eigenschaft programmierbarer Masken ist, dass sie die Vorlage nur mit einer bestimmten durch die Größe der Funktionseinheiten, im weiteren Pixel genannt, gegebenen Auflösung darstellen können. Der Begriff Auflösung wird hierbei so verwendet, dass er die Genauigkeit bezeichnet, mit der Kantenpositionen von Strukturen definiert werden können. Während bei der Nutzung herkömmlicher Masken die Positionsgenauigkeit, mit der Strukturkanten abgebildet werden, nur von der Auflösungsgrenze der Optikeinheit abhängt, ist beim Einsatz programmierbarer Masken in Kombination mit einer 1:1 Abbildung die Auflösung der Abbildung durch die Pixelgröße und das sich daraus ergebende Objektraster bestimmt.

Ein anderes photolithographisches Verfahren, das in der DE 103 17 050 A1 beschrieben wird, geht auf die Problematik des Verzuges im Substrat ein. Als Substrat kommen, insbesondere in der Leiterplattenfertigung, meist großflächige und im Verhältnis dazu dünne Substrate zum Einsatz, mit einer Dicke im Bereich von mehreren mm (Millimetern) bis hinunter zu wenigen µm (Mikrometern). Oftmals müssen mehrere Strukturierungen auf diesen Substraten erfolgen, und die dazwischenliegenden Produktionsschritte können hohe Temperaturunterschiede oder mechanische Beanspruchungen einschließen, welche zu einer Verzerrung der Substratoberfläche führen können. Um eine zweite Lage von Strukturen sauber so über die erste belichten zu können, dass die zusammengehörigen Strukturen aufeinanderfallen, wird in dem angegebenen Verfahren der Verzug des Substrates mittels der Positionserfassung vorhandener Alignierungsmarken anhand von Kamerabildern errechnet und während der Belichtung kompensiert. Bei dem angeführten Verfahren werden dazu die Strukturen einer Maske punktweise beleuchtet und gemäß vorher ermittelten Daten zur Verzugskorrektur solchermaßen verzerrt auf das Substrat abgebildet, dass der Verzug des Substrates kompensiert wird und die Alignierungsmarken der Maske auf diejenigen des Substrates fallen. Maske und Substrat sind bei dem genannten Verfahren über eine mechanische Vorrichtung fest beabstandet miteinander verbunden, und die Beleuchtungseinheit sowie die verzerrungskompensierende Abbildungseinheit, welche das Bild der Maske auf das Substrat überträgt und welche wiederum fest an die Beleuchtungseinheit gekoppelt ist, bewegen sich relativ dazu. Zur Verzerrungskompensation werden bewegliche Optikkomponenten innerhalb der Abbildungseinheit genutzt.

Hiervon ausgehend liegt der Erfindung die Aufgabe zugrunde, für das gattungsgemäße Verfahren einen weiteren Lösungsweg aufzuzeigen, um eine verbesserte und/oder hohe Auflösung zu erreichen. Insbesondere soll die Positionierung von auf dem Substrat abzubildenden Strukturkanten optimiert werden. Des Weiteren soll das gemäß der vorgenannten DE-A1 verzugskompensierte Abbildungsverfahren dahingehend erweitert werden, dass es zur Abbildung wenigstens einer programmierbaren Maske genutzt werden kann. Ferner soll zur Durchführung des Verfahrens die Verwendung einer Vorrichtung vorgeschlagen werden, welche bei einem einfachen und gleichwohl funktionssicheren Aufbau eine optimierte Auflösung und eine exakte Positionierung von Strukturkanten ermöglicht.

Die Lösung dieser Aufgabe erfolgt hinsichtlich des Verfahrens gemäß den Merkmalen des Patentanspruchs 1 und weiterhin gemäß den Merkmalen des auf die Verwendung gerichteten Patentanspruches.

Es wird zur Verbesserung der Positionierungsauflösung von Strukturkanten vorgeschlagen, die programmierbaren Masken mit vergrößerten Vorlagedaten zu laden und diese in der Abbildungsoptik auf das benötigte Bildraster zu verkleinern. Die Vorlagedaten werden um einen vorgegebenen oder vorgebbaren Faktor gegenüber den erforderlichen Bilddaten und dem Bildraster des Substrats vergrößert. Daraufhin erfolgt insbesondere mittels der optischen Einheit und/oder der optischen Abbildungs- und Korrektureinheit eine Verkleinerung gemäß den Bilddaten und dem Bildraster auf dem Substrat. Bevorzugt ist der genannte Faktor im Bereich von 1,4 bis 5 vorgegeben, vorteilhaft im Bereich von 1,6 bis 3,5, zweckmäßig im Bereich von 1,8 bis 2,5 und beträgt insbesondere im Wesentlichen 2. Der Verkleinerungsfaktor der optischen Einheit und/oder der optischen Abbildungs- und Korrektureinheit, welche im Strahlengang der elektromagnetischen Strahlung der Beleuchtungseinheit nach der programmierbaren Maske angeordnet ist, ist vorteilhaft im Wesentlichen gleich groß wie der vorgenannte Vergrößerungsfaktor. Wird mit der Vorrichtung mittels der Beleuchtungseinheit ein Beleuchtungsfleck auf der programmierbaren Maske erzeugt, so ist der Beleuchtungsfleck um den genannten vorgegebenen Faktor größer als die mittels der optischen Einheit und/oder Abbildungs- und Korrektureinheit nach entsprechender Verkleinerung auf dem Substrat abgebildete Einzelabbildung. Es sei ausdrücklich festgehalten, dass für das erfindungsgemäße Verfahren ebenso wie die Verwendung die Korrektur von etwaigen Verzerrungen keine zwingende Voraussetzung ist, sondern dass mittels der optischen Einheit und/oder der optischen Abbildungs- und Korrektureinheit grundsätzlich allein die Verkleinerung, bevorzugt entsprechend dem vorgenannten Vergrößerungsfaktor, erforderlich ist. Ferner ist im Rahmen der Erfindung der Vergrößerungsfaktor der Vorlagedaten, insbesondere an das Raster der zum Einsatz gelangenden programmierbaren Maske angepaßt und/oder auf jenes abgestimmt. Ferner sei hervorgehoben, dass erfindungsgemäß die abzubildenden Musterdaten in die programmierbare Maske eingelesen und mittels der bevorzugt verzerrungskompensierenden optischen Einheit abgebildet werden, und zwar unter Nutzung von verzahnten Mehrfachbelichtungen zur Erhöhung der Bildauflösung und/oder der Optimierung der Positionierung der Strukturkanten.

Bevorzugt wird die Erhöhung der Auflösung weiterhin dadurch erreicht, dass an Strukturkanten die programmierbare Maske so eingestellt wird, dass die Intensität der Belichtungsstrahlung nach Passieren der Maske dem Maß entspricht, in welchem die ursprüngliche Vorlagestruktur das entsprechende Rasterfeld füllen würde. Damit diese angepasste Intensität die Kantenlage von Strukturen entsprechend beeinflussen kann, müssen die Abbildungen der einzelnen Rasterpunkte überlappen. Zu diesem Zweck erfolgen erfindungsgemäß wenigstens zwei Belichtungen der gleichen photoempfindlichen Schicht und/oder der gleichen Photolackschicht, sei es in wenigstens zwei zeitlich nacheinander durchgeführten Belichtungsvorgängen oder in wenigstens zwei gleichzeitig durchgeführten Belichtungsvorgängen durch parallel arbeitende programmierbarende Masken und bevorzugt bewegliche optischen Komponenten und/oder insbesondere optischen Einheiten. Das Belichtungsraster wird bei gleicher Anzahl von Belichtungspunkten gestreckt und/oder vergrößert vorgegeben, wobei im gleichen Verhältnis die Anzahl der zeitlich nacheinander durchgeführten Belichtungsvorgänge erhöht wird oder im gleichen Verhältnis die Anzahl der gleichzeitig durchgeführten Belichtungsvorgänge erhöht wird. Das Abbildungsraster wird derart vorgegeben, dass es größer ist als das angestrebte Bildraster, insbesondere doppelt so groß und/oder entsprechend der Anzahl der Belichtungsvorgänge. Die Bildpunkte und/oder die Pixel der wenigstens zwei Beleuchtungsvorgänge werden räumlich versetzt zueinander vorgegeben, und zwar derart, dass die zur Erzeugung und zur Positionierung einer Strukturkante vorgesehene Flanke der Gesamt- oder Summenintensität auf dem Substrat kontinuierlich ansteigt oder abfällt. Diskontinuitäten der Flankensteilheit werden erfindungsgemäß vermieden. Die Flanken werden insbesondere durch Überlagerung der Randbereiche der Pixel oder der Einzelabbildungen für die Bildung der Strukturkanten vorgesehenen und überlagerten Belichtungsvorgänge erzeugt, wobei für wenigstens eine der genannten Pixel oder Einzelabbildungen die Intensität zur Positionierung der Strukturkante definiert vorgegeben und insbesondere reduziert wird. Die Intensität der die Struktur bildenden Pixel oder Einzelabbildungen wird derart vorgegeben, dass die Summenintensität der Bestrahlung des Substrats und/oder der gemeinsam in wenigstens zwei Belichtungsvorgängen bestrahlten photoempfindlichen Schicht und/oder Lackschicht über dem Schwellwert zur Durchbelichtung liegt. Erfindungsgemäß wird in einem vorgegebenen Bereich, in welchen die Flanke den Schwellwert schneidet, die Flankensteilheit kontinuierlich vorgegeben.

So wird beispielsweise bei zwei Belichtungsvorgängen bei der ersten Belichtung jeder zweite Rasterpunkt der Vorlage und/oder der programmierbaren Maske belichtet und in gleicher Weise werden bei dem nachfolgenden und/oder zweiten Belichtungsvorgang die zuvor ausgelassenen Rasterpunkte belichtet. Die Intensität der Beleuchtung wird dabei derart vorgegeben, dass erst nach Durchführung sämtlicher Belichtungsvorgänge an den aus zu belichtenden Stellen der gleichen photoempfindlichen Schicht bzw. der Photolackschicht die zur durchgehenden Belichtung der photoempfindlichen Oberfläche des Substrats notwendige Dosis überschritten ist. An denjenigen Punkten des Bildrasters, an welchen im Objektraster eine angepaßte Intensität zur Darstellung der Grenzen durch belichtete Strukturen benutzt werden, wird somit erreicht, dass die Dosis erst innerhalb des Rasterfeldes unter die Grenze fällt, und somit die Strukturkante an eine Stelle auftritt, welche zwischen den Abgrenzungen des Rasters liegt. Die genaue Lage hängt von der eingestellten Intensität ab, insbesondere der Intensität des Beleuchtungsflecks und/oder der Einzelabbildung, welche der Strukturkante zugeordnet sind und/oder mittels welchen die Strukturkante erzeugt wird. Die auf das Substrat und/oder die photoempfindlichen Schicht projizierten Einzelabbildungen weisen Randbereiche auf, in welchen die Strahlungsintensität der einzelnen Abbildungen oder Abbildungselemente kleiner ist als im Zentrum. Die Einzelabbildungen besitzen eine Intensitätsverteilung oder ein Intensitätsprofil derart, dass im Vergleich mit einem zentralen Bereich im Randbereich die Intensität abnimmt, beispielsweise nach Art einer Gaußschen Glockenkurve oder nach Art eines Trapezes. Die Einzelabbildungen der zeitlich nacheinander oder gleichzeitig durchgeführten Belichtungsvorgänge sind räumlich versetzt zueinander vorgesehen derart, dass für den Bereich der Strukturkante die Randbereiche der Einzelabbildungen und/oder Pixel der genannten Belichtungsvorgänge überlagert werden, wobei wenigstens für einen der genannten Einzelabbildungen und/oder der Pixel reduziert wird. Entsprechend der vorgegebenen und/oder eingestellten Intensität des der Strukturkante zugeordneten Pixels bzw. der Einzelabbildung, wird die Lage der Strukturkante definiert vorgegeben.

Besondere Ausgestaltungen oder Weiterbildungen der Erfindung sind in den Unteransprüchen sowie der Beschreibung der Ausführungsbeispiele angegeben.

Die Erfindung wird nachfolgend anhand der in der Zeichnung dargestellten Ausführungsbeispiele näher erläutert, ohne dass insoweit eine Beschränkung erfolgt.

Es zeigen in schematischen Darstellungen:
- Fig. 1: eine Ansicht der Vorrichtung,
- Fig. 2: überlagerte Beleuchtungsflecken und die Summenintensität der Einzelabbildungen bzw. Pixel auf dem Substrat,
- Fig. 3: Beleuchtungsflecken von zwei Beleuchtungsvorgängen,
- Fig. 4: in einem vorgegebenen Raster abgebildete Pixel und deren Summenintensität auf dem Substrat,
- Fig. 5: in einem feineren Raster abgebildete Pixel und deren Summenintensität auf dem Substrat,
- Fig. 6: die erfindungsgemäß für zwei Belichtungsvorgänge vorgegebenen Belichtungspunkte oder Pixel mit gestrecktem Belichtungsraster sowie die Summenintensität auf dem Substrat,
- Fig. 7: ein weiteres Ausführungsbeispiel mit parallel arbeitenden programmierbaren Masken,
- Fig. 8: eine Prinzipdarstellung einer Korrektur bzw. Bildverzerrung durch Aneinanderfügen von Einzelabbildungen.

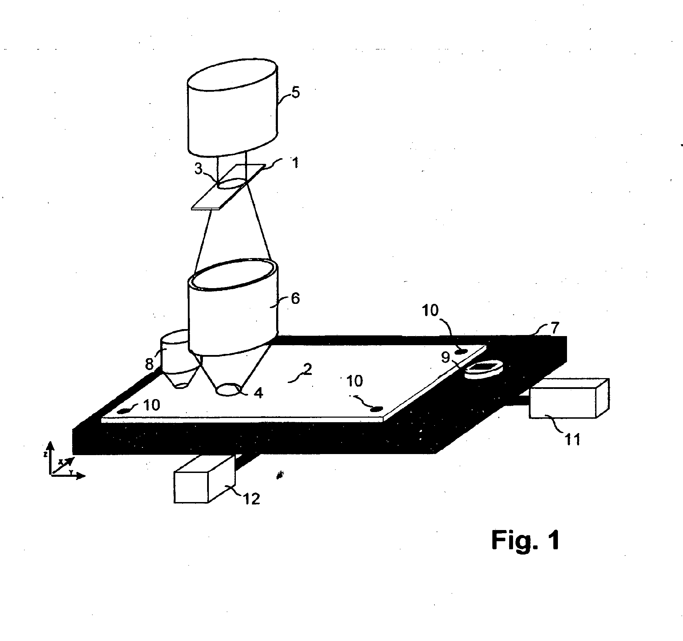

Gemäß dem in Fig. 1 dargestellten Ausführungsbeispiel der erfindungsgemäßen Vorrichtung ist das Substrat 2 auf einem Tisch 7 angeordnet, welcher mittels der beiden Antriebe 11 und 12 in zwei zueinander orthogonalen Richtung in einer XY-Ebene in bekannter Weise bewegbar ist, und zwar relativ zu den anderen, bevorzugt stationär angeordneten Komponenten, wie die Beleuchtungseinheit 5, die programmierbare Maske 1 und die optische Einheit 6. Es sei ausdrücklich darauf hingewiesen, dass für die Vorrichtung ebenso wie das vorgeschlagene Verfahren die Relativbewegung zwischen dem Substrat 2 einerseits und der programmierbaren Maske 1 sowie den übrigen Komponenten andererseits maßgebend ist. So kann im Rahmen der Erfindung das Substrat 2 stationär angeordnet sein, während die übrigen Komponenten, insbesondere die programmierbare Maske 1, mittels geeigneter Stelleinheiten, Antrieben usw. relativ zum stationär angeordneten Substrat 2 bewegbar sein können. Mittels der Beleuchtungseinheit 5 wird auf der programmierbaren Maske 1 der jeweilige Beleuchtungsfleck 3 erzeugt wird und als Einzelabbildung 4 auf dem Substrat 2 abgebildet wird. Die optische Einheit 6 enthält eine Abbildungs- und Korrektureinheit und befindet sich im optischen Pfad zwischen der programmierebaren Maske 1 und dem Substrat oder Nutzelement 2. Auf der Substratauflage und/oder dem XY-Tisch 7 ist eine Aligniermarke oder Justagekamera 9 angeordnet, insbesondere zur Ausrichtung auf eine Standardposition und/oder bezüglich der optischen Einheit 6. Des Weiteren weist das Substrat 2 Registriermarken 10 auf, welche insbesondere zur Justage des Optikpfades mittels der Substratkamera 8 erfaßt werden, wobei Ansteuerwerte gebildet werden, die insbesondere als Offsetwerte zur Korrekturberechnung und/oder der Ausrichtung des Substrats 2 auf der Substratauflage 7 oder für die Ausrichtung der optischen Einheit 6 in einer hier nicht weiter dargestellten Steuereinheit berücksichtigt werden. Die Beleuchtungseinheit 5 enthält eine Strahlungsquelle oder der Beleuchtungseinheit 5 ist eine Strahlungsquelle für elektromagnetische Strahlung, insbesondere eines Lasers, vorgeschaltet zur Erzeugung eines elektromagnetischen Strahlungsfelds. Über die Beleuchtungseinheit können auf der programmierbaren Maske Beleuchtungsflecken erzeugt werden. Die Beleuchtungsflecken werden in einem vorgegebenen Raster und/oder Array auf die Maske gegeben.

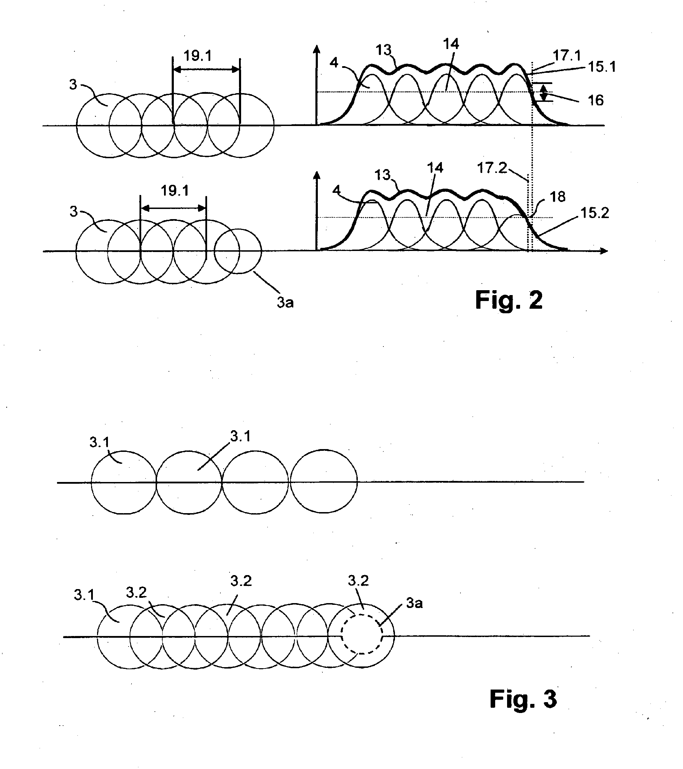

Fig. 2 zeigt die mittels der programmierbaren Maske erfolgenden Verfahrensschritte zur Erzeugung einer Struktur, wobei im linken Teil die Beleuchtungsflecken 3 und im rechten Teil die mittels der optischen Einheit auf dem Substrat bzw. dessen photoempfindlicher Schicht abgebildeten Pixel 4 sowie deren Summenintensität 13 dargestellt sind. Es sind zum einen im Pixelraster 19.1 in einer Linie dicht nebeneinander erste Beleuchtungsflecken 3 vorgesehen, welchen weitere Beleuchtungsflecken mit dem gleichen Pixelraster 19.1, jedoch um ein halbes Pixelraster versetzt, zugeordnet und/oder überlagert sind. Die Linie entspricht einer Spalte oder Zeile des abzubildenden Musters, welches insgesamt eine Mehrzahl von Spalten und Zeilen in einem Array und/oder Raster aufweist. Die Pixel 4 besitzen einen glockenförmigen oder nach Art einer Gaußschen Verteilungskurve vorgegebenen Intensitätsverlauf, wobei in den Randbereichen die Intensität kleiner als im Zentrum ist. Die im oberen Teil der Fig. 2 dargestellte Summenintensität 13 weist entsprechende seitliche Flanken 15.1 auf. Die Strahlungsintensität der Beleuchtungsflecken und somit auch der Pixel 4 ist derart auf den Photolack oder allgemein die photoempfindliche Schicht abgestimmt, dass deren Schwellwert 14 zum Durchbelichten die seitlichen Flanken 15.1 schneidet, und zwar in bevorzugter Weise in einem Bereich 16 mit kontinuierlicher Steigung der Flanke 15.1. Die Flanke 15 wird durch die Überlagerung der räumlich in der genannten Linie bzw. in einer Spalte oder Zeile versetzten Pixeln erzeugt, wobei die Intensität wenigstens eines randseitigen Pixels, hier Pixel 3a, zur Positionierung der Strukturkante verändert wird. Der Schnittpunkt definiert somit die Lage der Lackkante und/oder Strukturkante 17.1.

Wie im unteren Teil der Fig. 2 dargestellt, besitzt der im rechten Rand der Gesamtheit der Beleuchtungsflecken vorhandene Beleuchtungsfleck 3a eine geringere Beleuchtungsintensität als die übrigen Beleuchtungsflecken 3. Somit ist die Summenintensität am rechten Rand entsprechend der Flanke 15.2 reduziert, wodurch ist eine Verschiebung 18 der Lackkante bzw. der Strukturkante 17.2 erreicht ist. Es ist erfindungsgemäß von besonderer Bedeutung, dass der Schwellwert 14 und die Beleuchtungsintensitäten derart aufeinander abgestimmt sind, dass für den randseitigen Beleuchtungsfleck 3a die Veränderung und insbesondere Reduzierung der Beleuchtungsintensität derart erfolgt, dass der Schnittpunkt des Schwellwert 14 in dem Bereich 16 liegt, in welchem die Flankensteilheit kontinuierlich ist und/oder sich ändert, also keine Diskontinuitäten vorliegen. Durch Veränderung und insbesondere Reduzierung der Beleuchtungsintensität des randseitigen Beleuchtungsflecks 3a erfolgt erfindungsgemäß die Verschiebung 18 und letztendlich die exakte Positionierung der Lackkante und somit der Strukturkante 17.

In Fig. 3 sind die beiden Belichtungsvorgänge dargestellt, wobei im oberen Teil die Beleuchtungsflecken 3.1 des ersten Belichtungsvorgangs und im unteren Teil zudem die Beleuchtungsflecken 3.2 des zweiten Belichtungsvorgangs dargestellt sind, und zwar letztere räumlich um das halbe Pixelraster versetzt zu den Beleuchtungsflecken 3.1. Mit gestrichelter Linie ist der randseitige Beleuchtungsfleck 3a angedeutet und es sei festgehalten, dass bei Erhöhung der Beleuchtungsintensität, und zwar bei maximaler Beleuchtungsintensität entsprechend der randseitige Beleuchtungsfleck 3a dicht neben dem benachbarten Beleuchtungsfleck des zweiten Belichtungsvorgangs liegt.

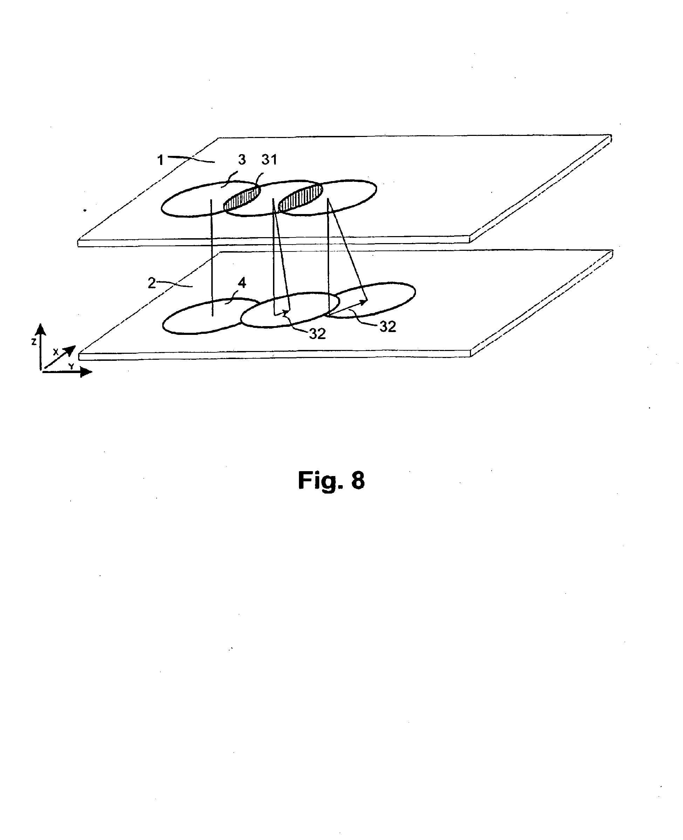

Es sei an dieser Stelle ausdrücklich darauf hingewiesen, dass die Beleuchtungsflecken an Stelle der erläuterten dicht nebeneinander erfolgenden Anordnung auch derart vorgegeben werden können, dass die Randbereiche überlappen, was nachfolgend anhand der Fig. 8 zur Verzugskorrektur noch erläutert wird, oder aber vorgegebene Abstände zueinander aufweisen können. Ferner können die Intensitäten der Beleuchtungsflecken andere Konturen aufweisen, beispielsweise trapezförmige oder mit geraden oder bogenförmigen Flanken. Maßgebend ist; dass die Summenintensität über die gesamte Breite der zu erzeugenden Struktur größer ist als der Schwellwert der photoempfindlichen Schicht und zudem die Seitenflanken den Bereich mit kontinuierlicher Flankensteilheit aufweisen, um einen definierten Schnittpunkt mit dem Schwellwert vorzugeben.

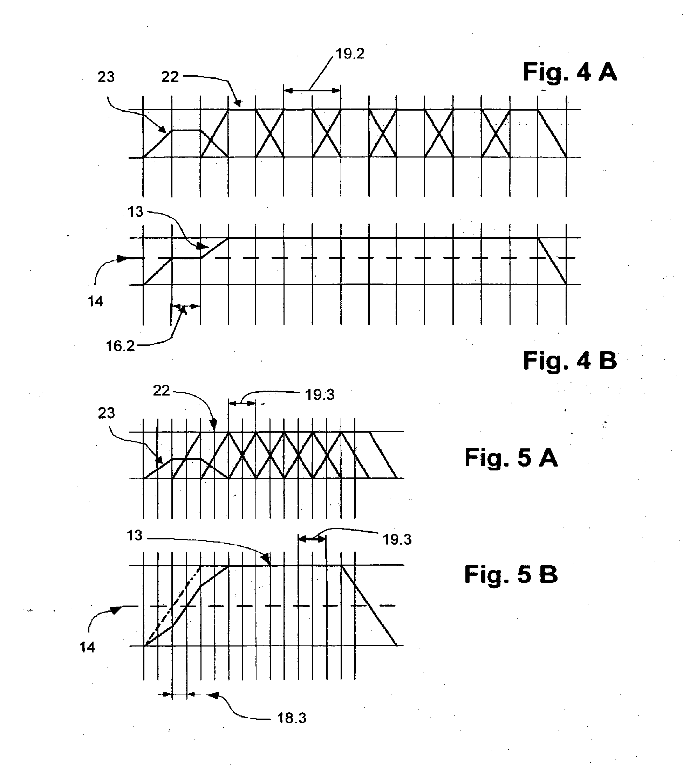

Die erfindungsgemäßen Wirkungszusammenhänge und Funktionsweisen werden anhand der Fig. 4 und 5 erläutert, welche aber nicht Gegenstand der Erfindung sind. Da der Abbildungsmaßstab, das Bildfeld, die Auflösung und die Überlappung nicht unabhänig einzustellen sind, ergibt sich typischerweise eine Situation wie in Fig. 4A dargestellt ist. Die im vorgegebenen Raster 19.2 abgebildeten Pixel überlappen nur teilweise. Wird ein randseitiger Pixel oder Randpixel 23 gegenüber den Innenpixeln 22, in der Intensität abgesenkt, ergibt sich ein ungünstiger Intensitätsverlauf 13 auf dem Substrat gemäß Fig 4B. Die Strukturkante auf dem Substrat wird durch die eingestrahlte Intensität und der Mindestintensität der Schwelle 14 definiert. Gemäß Fig. 4B weist die linke Flanke der Summenintensität 13 einen Bereich 16.2 auf, dessen Belichtungsintensität nahe bzw. auf der Schwelle 14 liegt, und folglich ist die Strukturkante im Bereich 16.2 nicht eindeutig bestimmt. Der Bereich 16.2 ist eine Diskontinuität der Flankensteilheit, so dass ein definierter Schnittpunkt mit der Schwelle 14 und somit eine definierte Positionierung der Strukturkante nicht möglich ist.

Um diese nachteilige Situation zu umgehen, wurde bisher vorgeschlagen, bei gleicher Auflösung den Abbildungsmaßstab derart zu verändern, dass gemäß Fig. 5A sich ein feineres Raster 19.3 ergibt und die Pixel stärker überlappen. In dieser Anordnung hat gemäß Fig. 5B die Summenintensität 13 eine eindeutige Schnittstelle mit der für den Lack typischen Schwelle 14. Damit ergibt sich eine eindeutige Verschiebung 18.3 der Strukturkante durch das in der Intensität abgesenkte randseitige Pixel 23

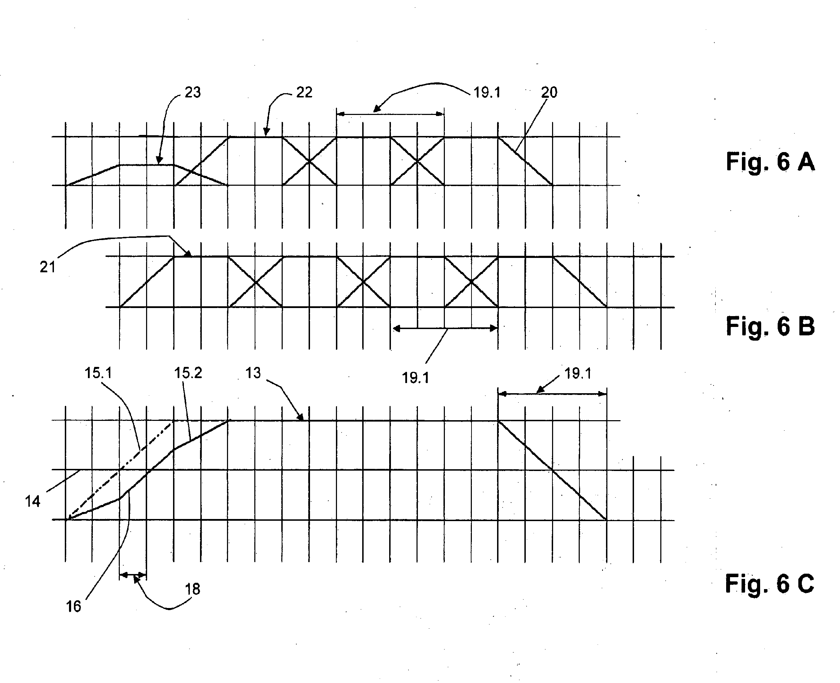

Es wird im Rahmen der Erfindung vorgeschlagen, den Abbildungsmaßstab zu reduzieren und die Bildfläche und/oder die Struktur und /oder deren photoempfindliche Schicht mehrfach zu belichten, wie in Fig. 6 dargestelit. Zunächst ergibt sich eine ungenügende Überlappung der Pixel 22 und 23 durch das gestreckt Pixelraster 19.1 gemäß Fig. 6A. Durch die zweite Belichtung gemäß Fig. 6B, mit dem gleichen aber räumlich in der Linie bzw. Spalte oder Zeile versetzten Raster 19.1 wird jedoch eine günstige Summenintensität 13 gemäß Fig. 6C erreicht. Ohne Intensitätsabsenkung des randseitigen Pixels 23 besitzt die Summenintensität 13 die Flanke 15.1 mit gleichförmiger Flankensteilheit. Durch Absenken der Intensität des Randpixels 23 wird die Seitenflanke 15.2 erzeugt, welche den Schwellwert 14 definiert schneidet. Durch Verändern der Beleuchtungsintensität des Randpixels 23 vom maximalen Wert bis zu dem entsprechend Fig. 6A abgesenkten Wert, wird somit eine definierte Verschiebung 18 der Lackkante und der Strukturkante vorgenommen. Die Strukturkante kann somit definiert positioniert werden. In dieser Anordnung ist der Schnittpunkt der Summenintensität 13 mit dem Lackschwellwert und damit die Strukturkante eindeutig definiert. Die Position der Strukturkante wird somit nicht mehr durch die Pixelgröße und das Objektraster bestimmt, sondern erfindungsgemäß kann die Strukturkante innerhalb des Rasterfeldes entsprechend der Größe der Verschiebung bzw. Verschiebungsbereichs 18 positioniert werden, wodurch eine erhebliche Verbesserung der Auflösung erreicht wird. Zugleich ist der Durchsatz nicht reduziert, da die doppelte Fläche zweimal belichtet wurde.

Die Anzahl von zwei überlagerten Belichtungsvorgängen stellt keine Einschränkung der Erfindung dar, sondern auch häufigere Belichtungsvorgänge genutzt werden können. Ferner können für die wenigstens zwei überlagerten Belichtungsvorgänge mehrere getrennte Strahlwege genutzt werden. Unabhängig davon, ob zur Erreichung einer hohen Auflösung und einem hohen Durchsatz die Belichtungsvorgänge zeitlich nacheinander durchgeführt werden oder die Belichtungsvorgänge gleichzeitig, insbesondere mittels parallel arbeitenden programmierbaren Masken, durchgeführt werden, wird erfindungsgemäß das Belichtungsraster bei gleicher Anzahl von Belichtungspunkten gestreckt. Ferner sei festgehalten, dass das Abbildungsraster wenigstens doppelt so groß ist wie das angestrebte Bildraster. Weiterhin ist es, wie eingangs erläutert, von besonderem Vorteil, die Vorlagedaten der programmierbaren Maske um einen vorgegebenen Faktor größer vorzugeben als die erforderlichen Bilddaten und/oder des Bildrasters des Substrats. Mittels der durch die optische Einheit entsprechend vorgegebene Verkleinerung auf dem Substrat im Rahmen der Erfindung erreicht.

Wird das oben beschrieben erfindungsgemäße Überlagerungsverfahren durch mehrere Strahlengänge realisiert ergibt sich eine proportionale Durchsatzsteigerung.

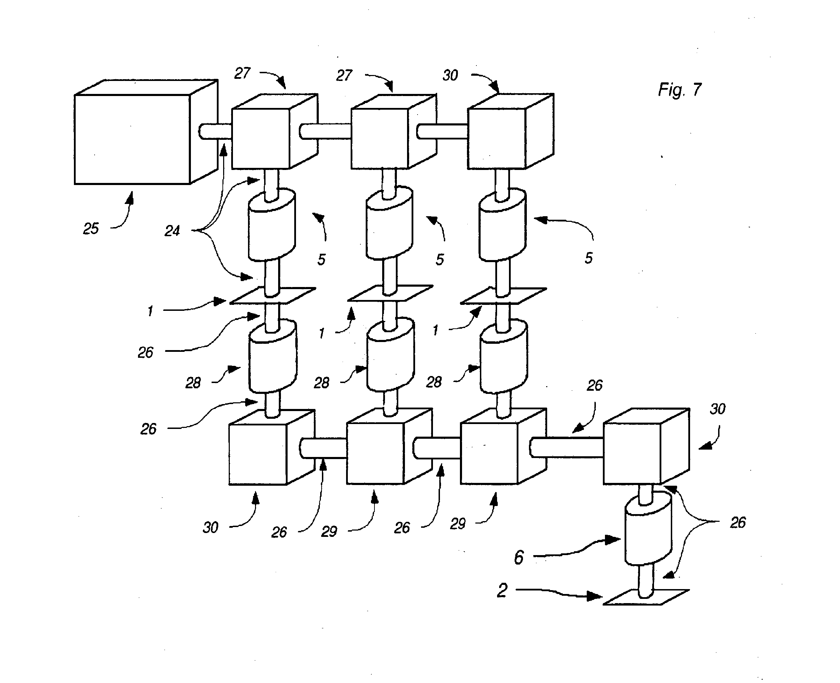

Eine Vorrichtung für mehrere parallel arbeitende Strahlengänge ist in Fig. 7 dargestellt. Die elektromagnetische Strahlung 24, mit geeigneter Wellenlänge zur Belichtung der photoempfindlichen Schicht bzw. des Photolackes, aus der Quelle 25, wird mittels der Einheiten 27 zur Strahlaufspaltung aufgespalten und dient über die jeweiligen Beleuchtungseinheiten 5 zur Beleuchtung mehrerer programmierbarer Masken bzw. Modulatoren 1. Das räumlich modulierte Strahlungsfeld 26 und/oder die jeweiligen Strahlungsfelder 26 werden bevorzugt über die jeweilige Abbildungsoptik 28 durch eine Bildüberlagerungsoptik 29 zusammengeführt, wobei ferner wenigstens eine Einheit 30, zweckmäßig gemäß Zeichnung mehrere Einheiten, für die Bildumlenkung vorgesehen sind. Des Weiteren erzeugt das räumlich modulierte Strahlungsfeld mittels der optischen Einheit 6 auf dem Substrat 2 den Summenintensitätsverlauf.

Fig. 8 zeigt in einer Prinzipdarstellung die Vorrichtung und die Verfahrensschritte zur Kompensation von Verzerrungen oder Verzug des Substrats durch Aneinanderfügen von Einzelabbildungen 4. Ein Teilbereich der programmierbaren Maske 1 wird auf dem Substrat 2 abgebildet, wobei mittels der Beleuchtungseinheit auf der Maske 1 ein Beleuchtungsfleck 3 erzeugt wird und als Einzelabbildung 4 auf dem Substrat 2 abgebildet wird. Die gesamte Abbildung wird aus überlappenden Einzelabbildungen 4 zusammengesetzt, wobei hier der Einfachheit halber jede Einzelabbildung eine unverzerrte 1:1 Abbildung der Maske bzw. des zugeordneten jeweiligen Beleuchtungsflecks 3 ist. Es sei an dieser Stelle darauf hingewiesen, dass statt dessen beim erfindungsgemäßen Verfahren vergrößerte Vorlagedaten und/oder gegebenenfalls vergrößerte Beleuchtungsflecke vorgesehen werden können, welche mittels der zwischen der programmierbaren Maske 1 und dem Substrat 2 angeordneten optischen Einheit entsprechend verkleinert werden. Eine Verzerrung der Gesamtabbildung wird durch eine Verschiebung der Einzelabbildungen 4 auf dem Substrat durch einen Korrekturvektor 32 vorgegeben. Eine Vermessung des Substrats 2 wird durch Vermessen von Markierungen, wie insbesondere Registriermarken oder Alignierungsmarken auf der Maske 1 und/oder dem Substrat 2, durchgeführt oder durch Vorgabe von Verzerrungswerten berechnet. In bevorzugter Weise ist ferner eine Kombination von Meßwerten und Vorgabewerten durchführbar. Aufgrund der Vermessung werden die Relativpositionen von Marken des Substrats und/oder der Maske bestimmt, wobei die Abbildung entsprechend den erfaßten und/oder errechneten und/oder im Voraus ermittelten Verzerrungen zu deren Kompensation mittels des Korrekturvektors 32 kompensiert und/oder verschoben werden.

Weisen die nebeneinander liegenden Beleuchtungsflecken 3 gemeinsame Überlappungsbereiche 31 auf, so bewirkt die Verschiebung und/oder Korrektur im Überlappungsbereich eine Unschärfe, wobei entsprechend einer tolerierbaren Unschärfe sowie der Größe des Überlappungsbereichs 31 der maximale Versatz zweier benachbarter Einzelabbildungen 4 vorgegeben wird. Es sei angemerkt, dass erfindungsgemäß bei der Vorrichtung und dem Verfahren die Beleuchtungseinheit und die optische Einheit relativ zur programmierbaren Maske 1 und/oder dem Substrat 2 bewegt werden, wobei ferner Verzerrungen des Substrats erfaßt werden. In Abhängigkeit der erfaßten Verzerrungen wird mittels der optischen Einheit die Abbildung der programmierbaren Maske und/oder deren Teilbereiche verzerrt und den Verzerrungen des Substrats angepaßt. In Abhängigkeit der Verzerrungen des Substrats 2 werden die den jeweiligen Beleuchtungsflecken entsprechenden Einzelabbildungen bevorzugt überlappend auf dem Substrat verschoben und/oder kontinuierlich aneinander gefügt. Die Beleuchtungsintensität der Beleuchtungsflecken ist zweckmäßig in den Randbereichen um einen vorgegebenen Betrag kleiner vorgegeben als im Zentrum des Beleuchtungsflecks, welcher insbesondere eine Intensitätsverteilung entsprechend einer Gaußschen Glockenkurve aufweist.

Im übrigen sei festgehalten, dass bei dem erfindungsgemäßen Verfahren, sei es für die definierte Positionierung von Strukturkanten allein oder in Kombination mit der Verzerrungskompensation die Bewegung des oder der Beleuchtungsflecke 3 auf der programmierbaren Maske aus zwei Bewegungen zusammengesetzt wird, bevorzugt aus einer schnellen Scanbewegung der Beleuchtung und einer hierzu langsameren, insbesondere orthogonalen Bewegung. Ferner wird entsprechend der Position des Beleuchtungsflecks 2 auf der programmierbaren Maske die Korrektur der Einzelabbildungen auf dem Substrat 2 gesteuert, wobei zur Korrektur und/oder Ansteuerung des Beleuchtungsflecks entsprechend dem Korrekturvektor 32 die zusammengesetzte Bewegung berücksichtigt wird.

### Bezugszeichen

- 1: programmierbare Maske
- 2: Substrat / Nutzelement
- 3: Beleuchtungsfleck
- 4: Einzelabbildung / Pixel
- 5: Beleuchtungseinheit
- 6: optische Einheit / Abbildungs- und Korrektureinheit
- 7: Substratauflage / XY-Tisch,
- 8: Substratkamera
- 9: Justagekamera
- 10: Registriermarke / Alignierungsmarke
- 11: Y-Antrieb
- 12: X-Antrieb
- 13: Summenintensität auf dem Substrat / der photoempfindlichen Schicht
- 14: Schwellwert des Photolacks der photoempfindlichen Schicht
- 15: Flanke
- 16: Bereich von 15
- 17: Lackkante / Strukturkante
- 18: Verschiebung der Lackkante /-Strukturkante
- 19: Pixelraster
- 20: Einzel Intensitätsprofile geschrieben im ersten Belichtungsvorgang
- 21: Einzel Intensitätsprofile geschrieben im zweiten Belichtungsvorgang
- 22: Intensitätsverlauf eines Abbildungselements
- 23: Pixel mit reduzierter Intensität
- 24: elektromagnetisches Strahlungsfeld
- 25: elektromagnetische Strahlungsquelle
- 26: moduliertes Strahlungsfeld
- 27: Strahlaufspaltung
- 28: Abbildungsoptik
- 29: Bildübertragungsoptik
- 30: Bildumlenkung
- 31: Überlappungsbereich
- 32: Korrekturvektor

## Patentansprüche

1. Verfahren zum Abbilden eines mittels einer programmierbaren Maske (1) erzeugten Musters auf einem Substrat (2), welches eine photoempfindliche Schicht aufweist, wobei mittels der Beleuchtungseinheit auf der Maske (1) Beleuchtungsflecken (3) in einem Belichtungsraster erzeugt werden und über eine optische Einheit (6) dem Muster entsprechende Einzelabbildungen (4) in einem Bildraster auf dem Substrat (2) erzeugt werden,
**dadurch gekennzeichnet,**
**dass** wenigstens zwei Belichtungsvorgänge der photoempfindlichen Schicht durchgeführt werden, deren Beleuchtungsflecke (3) oder Belichtungspunkte gegeneinander versetzt vorgegeben werden,
und **dass** das Belichtungsraster bei gleicher Anzahl von Beleuchtungsflecken (3) oder Belichtungspunkten gegenüber dem Bildraster gestreckt wird und im gleichen Verhältnis die Anzahl der Belichtungsvorgänge erhöht wird oder dass das Belichtungsraster um einen vorgegebenen Faktor gegenüber dem Bildraster gestreckt wird, welcher der Anzahl der Belichtungsvorgänge entspricht, wobei die gesamte Anzahl der Beleuchtungsflecken (3) oder Belichtungspunkte insbesondere im Wesentlichen gleich groß ist wie im Falle eines einzigen Belichtungsvorgangs ohne Streckung des Belichtungsrasters.

2. Verfahren nach Anspruch 1, **dadurch gekennzeichnet, dass** die Belichtungsvorgänge zeitlich nacheinander durchgeführt werden.

3. Verfahren nach Anspruch 1, **dadurch gekennzeichnet, dass** das abzubildende Muster in mehreren programmierbaren Masken (1) erzeugt wird und dass das Belichtungsraster im gleichen Verhältnis der Anzahl der gleichzeitig durchgeführten Belichtungsvorgänge durch parallel arbeitende programmierbare Masken (1) und insbesondere bewegliche optische Komponenten erhöht wird.

4. Verfahren nach Anspruch 3, **dadurch gekennzeichnet, dass** die gleichzeitig abgebildeten Maskenmuster auf die gleiche Substratposition oder auf verschiedene Substratpositionen projiziert werden.

5. Verfahren nach einem der Ansprüche 1 bis 4, **dadurch gekennzeichnet, dass** die Intensität des zur Erzeugung einer Strukturkante (17) vorgesehenen Beleuchtungsflecks (3a) und/oder Pixels (23) im Vergleich mit den übrigen für die Erzeugung einer Struktur vorgesehenen Beleuchtungsflecken (3) und/oder Pixel verändert und inbesondere reduziert wird.

6. Verfahren nach einem der Ansprüche 1 bis 5, **dadurch gekennzeichnet, dass** die Summenintensität (13) der auf dem Substrat (2) abgebildeten Pixel Flanken (15) aufweist, welche derart vorgegeben werden, dass ein eine kontinuierliche Steigung aufweisender Bereich (16) einen definierten Schnittpunkt mit dem Schwellwert (14) der photoempfindlichen Schicht des Substrats (2) bildet, wobei der genannte Schnittpunkt durch Veränderung und/oder Reduzierung der Intensität des zugeordneten Beleuchtungsflecks (3a) und/oder Randpixels (23) vorgegeben wird, wobei eine exakte Positionierung der Kante der photoempfindlichen Schicht und somit der Strukturkante (17) vorgegeben wird.

7. Verfahren nach einem der Ansprüche 1 bis 6, **dadurch gekennzeichnet, dass** zur Verschiebung (18) und/oder Positionierung der Strukturkante (17) die Intensität des zur Erzeugung der Struktur vorgegebenen Randpixels (23) und/oder des für die Erzeugung der Strukturkante vorgesehen Rand-Beleuchtungsflecks (3a) verändert und insbesondere gegenüber den Intensitäten der übrigen für die Erzeugung der Struktur vorgesehenen Beleuchtungsflecken (3) reduziert wird.

8. Verfahren nach einem der Ansprüche 1 bis 7, **dadurch gekennzeichnet, dass** das abzubildende Muster ausschnittsweise in und/oder mit der programmierbaren Maske (1) erzeugt wird und mittels der Beleuchtungseinheit (5) und der optischen Einheit (6), insbesondere mit beweglichen Komponenten verzerrungskompensiert auf dem Substrat (2) derart abgebildet wird, dass die Ausschnittsabbildungen die Gesamtvorlage darstellen, und/oder dass das abzubildende Muster abschnittsweise mittels der optischen Einheit (6) derart auf dem Substrat (2) abgebildet wird, dass zuvor ermittelte Verzerrungen kompensiert werden.

9. Verwendung einer Vorrichtung zur Durchführung des Verfahrens nach einem der Ansprüche 1 bis 8, enthaltend die programmierbare Maske (1), mit welcher ein Muster erzeugbar ist, das auf einer photoempfindlichen Schicht eines Substrats (2) abbildbar ist, wobei mittels der Beleuchtungseinheit (5) auf der Maske (1) Beleuchtungsflecken (3) erzeugt werden und die optische Einheit (6) dem Muster entsprechende Einzelabbildungen (4) auf dem Substrat (2) erzeugt werden, **dadurch gekennzeichnet,**
**dass** wenigstens zwei Belichtungsvorgänge der photoempfindlichen Schicht durchgeführt werden, deren Beleuchtungsflecke (3) gegeneinander versetzt vorgegeben werden,
und **dass** das Belichtungsraster bei gleicher Anzahl von Beleuchtungsflecken (3) gestreckt wird, und zwar im gleichen Verhältnis der Anzahl der Belichtungsvorgänge.

10. Verwendung nach Anspruch 9 derart, dass zur Positionierung der Strukturkante (17) nur der oder die Beleuchtungsflecke (3a, 23), welche zur Erzeugung einer Lackkante vorgesehen sind in ihrer Intensität verändert und insbesondere reduziert werden, und dass hierzu in der gleichen photoempfindlichen Schicht die wenigstens zwei Belichtungsvorgänge durchgeführt werden, wobei die Beleuchtungsflecken (3) des einen Belichtungsvorgangs bezüglich denen des anderen Belichtungsvorgangs räumlich versetzt zueinander vorgegeben werden.

## Claims

1. A method for imaging a pattern created by means of a programmable mask (1) on a substrate (2), which has a photosensitive layer, wherein illumination patches (3) are created on the mask (1) by means of the illuminating unit in an exposure raster and individual images (4) corresponding to the pattern are created in an image raster on the substrate (2) by means of an optical unit (6),
**characterised**
**in that** at least two exposure processes of the photosensitive layer are carried out, the illumination patches (3) or exposure points of which are predetermined in an offset manner with respect to each other,
and **in that** the exposure raster is stretched for the same number of illumination patches (3) or exposure points compared to the image raster and the number of exposure processes is increased in the same ratio or in that the exposure raster is stretched by a predetermined factor with respect to the image raster, which corresponds to the number of exposure processes, wherein the total number of illumination patches (3) or exposure points is in particular essentially equal to that in the case of a single exposure process without stretching the exposure raster.

2. The method according to Claim 1, **characterised in that** the exposure processes are carried out temporally successively.

3. The method according to Claim 1, **characterised in that** the pattern to be imaged is created in a plurality of programmable masks (1) and **in that** the exposure raster is increased in the same ratio as the number of exposure processes carried out simultaneously by parallel operating programmable masks (1) and in particular movable optical components.

4. The method according to Claim 3, **characterised in that** the simultaneously imaged mask patterns are projected onto the same substrate position or onto various substrate positions.

5. The method according to one of Claims 1 to 4, **characterised in that** the intensity of the illumination patch (3a) and/or pixel (23) provided for creating a structure edge (17) is changed and in particular reduced compared to the illumination patches (3) and/or pixels conventionally provided for creating a structure.

6. The method according to one of Claims 1 to 5, **characterised in that** the sum intensity (13) of the pixels imaged on the substrate (2) has flanks (15), which are predetermined in such a manner that a region (16) having a continuous pitch forms a defined point of intersection with the threshold value (14) of the photosensitive layer of the substrate (2), wherein the mentioned point of intersection is predetermined by changing and/or reducing the intensity of the assigned illumination patch (3a) and/or edge pixel (23), wherein an exact positioning of the edge of the photosensitive layer and therefore the structure edge (17) is predetermined.

7. The method according to one of Claims 1 to 6, **characterised in that** to shift (18) and/or position the structure edge (17), the intensity of the edge pixel (23) predetermined for creating the structure and/or of the edge illumination patch (3a) provided for creating the structure edge is changed and in particular is reduced compared to the intensities of the other illumination patches (3) provided for creating the structure.

8. The method according to one of Claims 1 to 7, **characterised in that** the pattern to be imaged is created in sections in and/or using the programmable mask (1) and is imaged by means of the illuminating unit (5) and the optical unit (6), particularly with movable components in such a distortion-compensated manner on the substrate (2), that the partial images illustrate the overall pattern and/or that the pattern to be imaged is imaged by means of the optical unit (6) on the substrate (2) in sections in such a manner, that previously detected distortions are compensated.

9. A use of a device for carrying out the method according to one of Claims 1 to 8, containing the programmable mask (1), using which a pattern can be created, which pattern can be imaged on a photosensitive layer of a substrate (2), wherein illumination patches (3) are created on the mask (1) by means of the illuminating unit (5) and the optical unit (6) creates individual images (4) corresponding to the pattern on the substrate (2),
**characterised**
**in that** at least two exposure processes of the photosensitive layer are carried out, the illumination patches (3) of which are predetermined in an offset manner with respect to each other,
and **in that** the exposure raster is stretched for the same number of illumination patches (3), specifically in the same ratio as the number of exposure processes.

10. The use according to Claim 9, such that to position the structure edge (17), only the illumination patch(es) (3a, 23), which are provided for creating a paint edge, are changed and in particular reduced in terms of the intensity thereof, and that to this end, in the same photosensitive layer, the at least two exposure processes are carried out, wherein the illumination patches (3) of the one exposure process are predetermined with reference to those of the other exposure process in a spatially offset manner with respect to one another.

## Revendications

1. Procédé pour la représentation d'un motif, produit à l'aide d'un masque programmable (1), sur un substrat (2) qui comprend une couche photosensible, dans lequel, au moyen de l'unité d'illumination, des spots d'illumination (3) sont produits dans une trame d'exposition lumineuse sur le masque (1) et, grâce à une unité optique (6), des représentations individuelles (4) correspondant au motif étant produites dans une trame d'image sur le substrat (2),
**caractérisé en ce que** l'on exécute au moins deux processus d'exposition lumineuse de la couche photosensible dont les spots d'illumination (3) ou points d'illumination sont prescrits de manière à être décalés les uns par rapport aux autres,
et **en ce que** la trame d'exposition lumineuse, avec un nombre identique de spots d'illumination (3) ou de points d'illumination, est étirée par rapport à la trame d'image et **en ce que** le nombre de processus d'illumination est augmenté selon le même rapport, ou bien **en ce que** la trame d'exposition lumineuse est étirée par rapport à la trame d'image de l'ordre d'un facteur prescrit qui correspond au nombre de processus d'illumination, le nombre total de spots d'illumination (3) ou de points d'illumination étant en particulier sensiblement égal à celui dans le cas d'un seul processus d'exposition lumineuse sans étirement de la trame d'exposition lumineuse.

2. Procédé selon la revendication 1, **caractérisé en ce que** les processus d'exposition lumineuse sont réalisés successivement dans le temps.

3. Procédé selon la revendication 1, **caractérisé en ce que** le motif à représenter est produit dans plusieurs masques programmables (1) et **en ce que** la trame d'exposition lumineuse est augmentée selon le même rapport que le nombre de processus d'exposition lumineuse réalisés simultanément grâce à des masques programmables (1) travaillant en parallèle et en particulier des composantes optiques mobiles.

4. Procédé selon la revendication 3, **caractérisé en ce que** les motifs de masque représentés simultanément sont projetés sur la même position de substrat ou sur différentes positions de substrat.

5. Procédé selon l'une des revendications 1 à 4, **caractérisé en ce que** l'intensité du spot d'illumination (3a) et/ou pixel (23) prévu pour la production d'une arête de structure (17) est modifiée, et est en particulier réduite en comparaison avec les autres spots d'illumination (3) et/ou pixels prévus pour la production d'une structure.

6. Procédé selon l'une des revendications 1 à 5, **caractérisé en ce que** l'intensité totalisée (13) des pixels représentés sur le substrat (2) présente des flancs (15), lesquels sont prescrits de manière à ce qu'une zone (16) présentant une pente continue forme un point d'intersection défini avec la valeur de seuil (14) de la couche photosensible du substrat (2), le dénommé point d'intersection étant prescrit grâce à une modification et/ou réduction de l'intensité du spot d'illumination (3a) et/ou pixel de bord (23) associé, un positionnement exact de l'arête de la couche photosensible, et donc de l'arête de structure (17), étant prescrit.

7. Procédé selon l'une des revendications 1 à 6, **caractérisé en ce que**, pour le décalage (18) et/ou le positionnement de l'arête de structure (17), on modifie l'intensité du pixel de bord (23) prescrit pour la production de la structure et/ou du spot d'illumination de bord (3a) prévu pour la production de l'arête de structure, et la réduit en particulier par rapport aux intensités des autres spots d'illumination (3) prévus pour la production de la structure.

8. Procédé selon l'une des revendications 1 à 7, **caractérisé en ce que** le motif à représenter est produit partiellement et/ou avec le masque programmable (1) et est représenté sur le substrat (2) à l'aide de l'unité d'illumination (5) et de l'unité optique (6), en particulier avec des composantes mobiles, de manière compensée concernant les distorsions, de façon à ce que les représentations partielles représentent le modèle global, et/ou **en ce que** le motif à représenter est représenté partiellement sur le substrat (2) au moyen de l'unité optique (6) de manière à ce que des distorsions préalablement déterminées soient compensées.

9. Utilisation d'un dispositif pour la mise en oeuvre du procédé selon l'une des revendications 1 à 8, comprenant le masque programmable (1) avec lequel un motif peut être produit, lequel peut être représenté sur une couche photosensible d'un substrat (2), des spots d'illumination (3) étant produits sur le masque (1) à l'aide de l'unité d'illumination (5) et des représentations individuelles (4) correspondant au motif étant produites sur le substrat (2) à l'aide du dispositif optique (6),
**caractérisée en ce que**
l'on réalise au moins deux processus d'exposition
lumineuse de la couche photosensible dont les spots d'illumination (3) sont prescrits de manière décalée les uns par rapport aux autres,
et **en ce que** la trame d'exposition lumineuse est étirée avec un nombre identique de spots d'illumination (3), à savoir selon le même rapport que le nombre de processus d'exposition lumineuse.

10. Utilisation selon la revendication 9 de manière à ce que, pour le positionnement de l'arête de structure (17), seulement le ou les spots d'illumination (3a, 23) qui sont prévus pour la production d'une arête de vernis sont modifiés concernant leur intensité ou sont en particulier réduits en intensité, et en ce que l'on effectue à cet effet, dans la même couche photosensible, les au moins deux processus d'exposition lumineuse, les spots d'illumination (3) de l'un des processus d'exposition lumineuse étant prescrits de manière décalée spatialement les uns par rapport aux autres compte tenu de ceux de l'autre processus d'illumination.
